Europäisches Patentamt

European Patent Office

Office européen des brevets

(11) Publication number: **0 297 637 B1**

## EUROPEAN PATENT SPECIFICATION

(45) Date of publication of patent specification: **11.11.92**

(51) Int. Cl.⁵: **H05H 1/34**, H05H 1/32, H05H 1/42, C23C 16/50

(21) Application number: **88201112.5**

(22) Date of filing: **02.06.88**

(54) **Method of treating surfaces of substrates with the aid of a plasma and a reactor for carrying out the method.**

(30) Priority: **30.06.87 NL 8701530**

(43) Date of publication of application:
**04.01.89 Bulletin 89/01**

(45) Publication of the grant of the patent:
**11.11.92 Bulletin 92/46**

(84) Designated Contracting States:
**AT BE CH DE ES FR GB GR IT LI LU NL SE**

(56) References cited:

**SYMPOSIUM ON ATOMIC AND SURFACE PHYSICS, SASP-PROCEEDINGS 1986, Oberdraun, AT, pages 181-187; D.C. SCHRAM et al.: "Physics of plasma etching and plasma deposition"**

**ISPC-7 CONFERENCE, July 1985, pages 698-703, paper no. P-7-5, Eindhoven, NL; G.M.W. KROESEN et al.: "A new approach of plasma deposition"**

**THIN SOLID FILMS, vol. 113, no. 2, March 1984, pages 135-149, Lausanne, CH; A. SHER-**

MAN: "Plasma-assisted chemical vapor deposition processes and their semiconductor applications"

(73) Proprietor: **TECHNISCHE UNIVERSITEIT EINDHOVEN**
**Postbus 513**
**NL-5600 MB Eindhoven(NL)**

(72) Inventor: **Schram, Daniel Cornelis**
**Ruusbroeclaan 10**
**NL-5611 LV Eindhoven(NL)**
Inventor: **Kroesen, Gerardus Maria Wilhelmus**
**Boschdijk 123-c**
**NL-5612 HB Eindhoven(NL)**

(74) Representative: **Flamman, Han**
**LIOC Patents and Licensing P.O. Box 85096**
**NL-3508 AB Utrecht(NL)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

The invention relates to a method of plasma treatment of substrate surfaces in which the plasma is generated in at least one plasma arc generator of the type, including a plurality of cascade plates, wherein the generator is flushed with flushing gas, wherein the plasma gets from the generator through a passage into the plasma-treatment-chamber, where the plasma pressure is substantially lower than that in the generator.

The term plasma generator as used herein is to be construed as meaning the part where the plasma is generated and the plasma-treatment-chamber is to be construed as meaning the part where the surface-treatment takes place. Treatment of substrate surfaces with the aid of plasma as described herein is to be construed as meaning the processes of plasma-etching, plasma-deposition, plasma-polymerisation or plasma-modification; that is to say the application of a layer of material onto, or removal of a layer of material from, the substrate or the modification of the surface structure of the substrate using a plasma. Such a method is known from the proceedings of the ISPC-VII conference, Eindhoven, 1985, pages 698 - 703, paper No.P-7-5, by G.M.W.Kroesen (inventor) et al and from the SASP proceedings Obertraun, Austria, 1986, pages 181 - 187 by D.C.Schram (inventor) et al. According to this known method as disclosed in these publications, it is only suitable for plasma deposition with the aid of gaslike reactants; plasma production and surface treatment is spatially achieved insofar that the plasma in the reactant to be used is generated In a cascade-arc, whereafter it is transported to the substrate to be treated through supersonic expansion in a vacuum system in the form of strongly flowing plasma-stream, and which substrate can form a part of an extra discharge in order to increase the energy of the reactive plasma particles.

In such a method apart from by means of a cascade-arc, the plasma can be generated in a number of different ways according to the known technique such as by capacitively or inductively connected radio-frequency (RF) fields, microwaves or other direct-current (DC) or alternating-current (AC) arcs or discharges. From "Thin Solid Films", vol.113, Lausanne, March 1984, pages 135 - 149, by A.Sherman, ("Plasma assisted chemical vapour disposition processes and their semiconductor applications"), it is known to use in a process of this type, two chambers - one for generating the plasma and flushing it, and a second one, in which the reactant is introduced, for the plasma treatment.

The practice of the method described in the quoted publications entails a number of problems.

Firstly by the direct injection of a reactive gasmixture into the plasma generator, the plasma becomes contaminated in the cases where cathodes are used for high-temperature plasma generation (temperatures of over 2000 Kelvin for example). In such circumstances these cathodes undesirably react with reactive atoms (carbon, halogens and oxygen for example) originating from the reactant and are accompanied by the formation of compounds which are a gas, gaslike, vaporisations or sublimations which contaminate the plasma and subject the cathodes to wear.

Secondly, the presence of molecules (or particles) of electrically-conducting solid materials (such as wolfram or graphite) used for cathodes is undesirable in the surface treatment process. The disadvantage here is that particularly the heat developed causes the cathodes to partially melt and vaporise so that the plasma is contaminated even further.

Thirdly, the methods described in the quoted publications are unsuitable for the processing of reactants of non-gas-like form, which prevents the methods to be applied in cases where the surface treatment is required to be carried out with the aid of a material which is available only in a liquid or solid form.

Fourthly the first quoted publication (from a reference therein and as implied in the second publication) the aperture in the anode of the arc through which the plasma is extracted needs to have a diameter (1 mm in the publication) which is smaller than the plasma-channel (4 mm) which leads to a so-called sonic-nozzle and which may lead to an unexpected stagnation in the flow resulting in deposition of material onto places where such is undesirable.

Fifthly, from the publications it appears that the heat-load imposed on the substrates can only be influenced by essentially changing the energy and the abundancies of the active plasma particles; a process which is disadvantageous in itself because the quality of the surface- treatment is also essentially changed (the quality of the deposited layer in the case of plasma-deposition for example). The quoted influence (mainly lessening) of the heat-load is of importance with substrates that can stand only a limited degree of heat.

Sixthly, when employing the method described in the publications the material efficiency, i.e. the fraction of the supplemented quantity of reactant which also actually arrives on the required place (in this case the substrate) is uninfluenced.

The object of the invention is to provide a method and a reactor therefor operating according to the quoted principle and which does not exhibit the disadvantages of the known method and/or equipment.

To that end the method according to the invention is characterised in that a fluid reactant is introduced into the generator through at least one channel, located in one or between two plates, it being fed downstream with respect to the cathode-(s) and only after the flushing gas has passed said cathode(s). It is to be noted, that this includes the configuration, wherein the utmost plate serves as an anode and consequently may contain the channel. The fluid, which means gas-like or liquid reactant is first fed (upstream) to the plasma generator after the flushing gas has passed the cathode(s). The term flushing-gas used here is to be construed as meaning a gas free of fragments which could undesirably react with parts of the plasma generator. In particular, the cathode(s) of the plasma generator need to be protected against the penetrative effects of reacting fragments of the molecules composing the flushing-gas. To that end preferentially the method is further characterised in that the molecules from which the flushing-gas is built up, do not contain fragments which would react with the cathode material.

According to the invention, the effectiveness of the invented method can yet further be increased by strongly retarding or preventing back diffusion of (parts of) the reactant to the cathode(s) by the flushing gas flowing with a flow velocity of at least 1 meter/sec., preferably with a velocity of 10 meter/sec.

The pressure in the plasma generator then is higher than 0.1 bar.

According to the invention, the secondly quoted drawback of the known method can be overcome by maintaining during operation the temperature of the cathode(s) below the cathode material melting point. In a reactor according to the invention and by means of which the method according thereto is carried out, prevention of cathode melting can be achieved by manufacturing the cathode(s) from a material with a high electron-emission factor and preferably an alloy of between 0.1 to 10% thorium in wolfram. A known disadvantage of using these materials resulting from slow segregation of one of the material components to the cathode surface followed by vaporisation, does not play a significant role in the practice of the method according to the invention. This is because the ratio of the quantity of vaporised cathode-material and the supplemented quantity of reactant is very small (smaller than $1:10^9$ for example) which, in combination with a possibly increased gas-efficiency, only delivers a very minimum quantity of contaminant to the surface of the substrate to be treated.

According to the invention and in the case of the use of a liquid reactant, an other earlier quoted drawback of the known method can be overcome by injecting this reactant through the wall of the plasma generator via a single aperture having a diameter of 0.0001 to 0.5 mm, but preferably of 0.0005 to 0.1 mm. In order to prevent premature vaporisation, the liquid pressure at the aperture is preferably greater than the pressure in the plasma generator. If the liquid reactant has already been vaporised before it reaches the plasma in the plasma generator, then this is a case of a gas-like reactant. According to the invention the use of solid reactants, the gas-phase can be entered into by means of at least one discharge in the plasma treatment-chamber and/or the plasma generator. The reactant then is subjected to bombardment by reactive particles (electrons, ions) with higher energy (200 electron-volts for example) so that the reactant will vaporise or sublimate. Once in the gas-phase it will be transported by the flushing-gas at a very fast rate and with a large yield to the substrate to be treated.

According to the invention, the fourth quoted drawback of the known method can be overcome by geometrically arranging the plasma generator(s) and the plasma passage (inlet(s)) in a reactor such that when viewed in the direction-of-flow there is no sudden restriction of the channel(s). Thus stagnation of the flow and deposition of the material in places where it is not wanted is prevented. Preferably the diameter of the channel formed by the plasma generator(s) and the plasma passage(s) changes gradually when viewed in the direction of flow with respect to the cathode(s). The only possible general drawbacks still clinging to the solutions such as the fact that the pressure at the end of the plasma generator is relatively fairly low which could lead to an undesirably high temperature and spatial expansion of the plasma, may be overcome by a specially constructed plasma generator which either takes away, or is insensitive to, the effects causing such drawbacks.

According to the invention the fifthly quoted drawback of the known method is overcome by making adjustable between zero and 100000 liters/sec., but preferably between 50 and 1000 liters/sec., the rate at which the plasma-treatment chamber is pumped out. This can be achieved by for example fitting a (infinitesimally, or step-by-step variable) flow-regulating valve in the pump pipeline. The resulting plasma stream can now be varied by a diffusion process related to the diameter of the plasma stream itself together with the rate at which the plasma particles are transported to the substrate to be treated, thus implying that the density ratio and the energies of the said particles hardly change. This results in the imposition of a controllable particle-bundle-loading of the said substrate of which the deposited quantity of particles (and thus the energy also) can be set per unit of surface-area without actually changing the other experimental parameters.

According to the invention, the sixth drawback of the known method can be overcome if the diameter of the plasma-stream in the plasma generator generated, is controlled (actively influenced), which means: influencing the process by means other than varying the pump speed. If the material efficiency needs to be reduced then, according to the invention, such influence preferably is exercised by directing the already quoted plasma-stream through a 'skimmer'. If on the other hand the efficiency needs to be increased, then the quoted influence is preferably exercised by setting up a magnetic-field. A skimmer cuts a part of the quoted plasma-stream as it were such, that the other part of the stream does not come in contact with the substrate to be treated. As opposed to this, a magnetic field holds the reactive (particularly the charged) plasma-particles together and increases the intensity of the plasma-stream which in this case is coupled to the decreasing diameter of the plasma-stream.

For good order's sake it needs to be mentioned here that the previously quoted supplementation of the reactant to the plasma generator can take place at any arbitrary place in the plasma generator, so also at the extreme end in this case at the plasma (inlet) passage.

According to the invention the temperature of the substrate to be treated can be set to a value between 70 and 1500 Kelvin and preferably between 273 and 1000 Kelvin. Each specific process for surface-treatment to which the method according to the invention is applied has its own optimum temperature at which the process proceeds in the most desirable manner.

The invention is further described with reference to drawings of an embodiment thereof and constructional drawings of a reactor according to the invention in which:

Figure 1 shows a schematic longitudinal cross-section of the reactor according to the invention;

Figure 2 shows a cascade-arc plasma generator;

Figure 3 shows a cross-section of a passage for gas-like reactants into the cascade-arc described with reference to figure 2;

Figure 4 shows how liquid reactants are injected into the cascade-arc shown in figure 2;

Figure 5 shows how solid reactants can be subjected to a discharge which vaporises, sublimates or sputters the material;

Figure 6 shows the way in which a nozzle may be designed in order to prevent flow stagnation to arise.

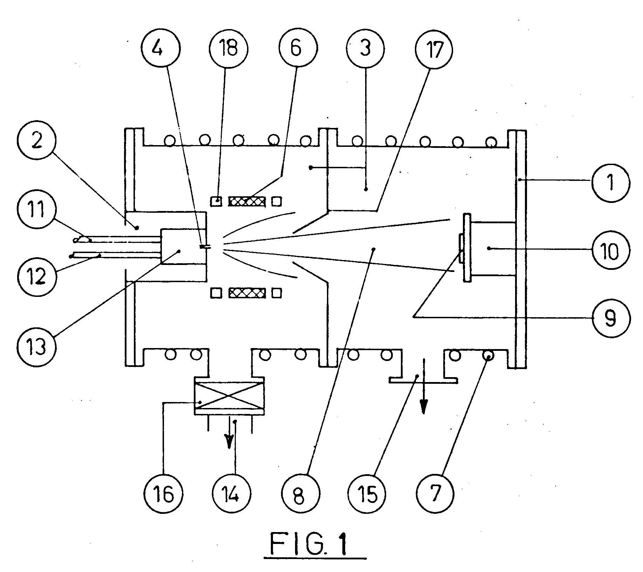

The embodiment of the reactor according to the invention shown in fig.1 to 6 comprises a housing 1 which incorporates a chamber 2 in which a plasma generator 13 (schematically illustrated in boxlike form) is accommodated together with a plasma-treatment chamber 3. A plasma-inlet 4 preferably incorporates a nozzle the end of which emerges into the left part of the treatment chamber 3. The generated plasma-stream 8 is directed to the surface 9 of the substrate to be treated, which substrate is held in place by a holder 10 which is maintained at a temperature in the range of 70 to 1000 Kelvin by means of a cooling-channel and/or built-in heating element (not shown in fig.1). The holder is also electrically insulated with respect to the housing 1 by which means it can form part of one or more extra discharges in the plasma treatment-chamber 3. In the case of a liquid or gas-like reactant being used, injection takes place into the plasma generator 13 via the inlet 11 whilst the flushing-gas is injected via the inlet 12 in order to make (semi-)continuous operation of the reactor possible. The flushing-gas can consist of an arbitrary mixture of gases which do not give rise to any fragments after separation, which could damage parts of the plasma generator 13, such as for example inert gases, hydrogen and nitrogen. The ratio between the injected quantity of flushing-gas and of the reactant (expressed in $m^3$/sec. at STP (standard temperature and pressure) gas equivalent i.e. 273 Kelvin and 1 bar, lies in the range 1 to 1000, preferably in the range of 8 to 400. The liquid or gas-like reactant preferably is composed of at least one separable and ionisable compound such as (possibly halogenated) hydrocarbons.

In order to operate a controlled plasma surface-treatment process without the presence of undesirable products in the plasma-stream 8, the process according to the invention is carried out whilst maintaining the pressure in the plasma generator 13 above 0.1 bar., preferably in the range 0.1 to 3.5 bar. The plasma-chamber 3 preferably operates at a pressure of below 0.05 bar (= 5kPa) and particularly below 200 Pa, independently of the adjustable pressure of the injected quantity of flushing-gas and/or reactant. These pressures can be achieved by pumping out the plasma treatment-chamber 3 via a regulating valve 16 at the outlet 14 using for example a Roots-blower (not shown in fig.1) whilst via the outlet 15 an oil diffusion pump maintains the housing 1 at a low pressure ($10^{-3}$ Pa) when the reactor is not in use, to prevent fouling up. A water-cooled skimmer 17 may form a part of the plasma treatment-chamber 3, which may influence the diameter of the plasma-stream 8. If required, the magnetic coils 7 can generate a magnetic-field which may again influence the diameter of the plasma-stream 8. Solid matter reactants are mixed with the plasma-stream 8 after they have been freed from the solid-phase by a sputtering discharge of which the cathode 6 (of copper for example) is the reactant and the anode 18 is electrically insulated from the housing 1.

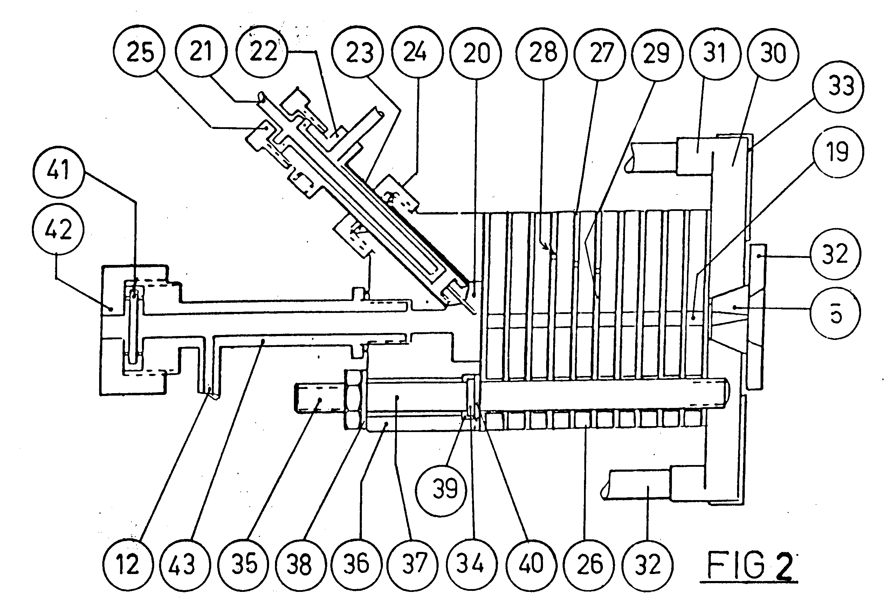

As already stated, a high temperature plasma-stream is generated, preferably in a cascade arc. Figure 2 shows in principle a construction which incorporates a central channel 19 with a length for example of 40 to 80 mm and a diameter of 2 to 6 mm, through which flows, during operation, direct-current electricity of between 20 to 200 A from the nozzle-like anode 5 to three cathode tips 20 (of which only one is shown in fig.2). The three cathode tips 20 made of an alloy of 2% thorium in tungsten (preferably arranged symmetrically around the central channel 19) are mounted in hollow holders 22 through which cooling water is fed through the duct 21. The holders 22 are at least partially enclosed in a sleeve 23 made e.g. of quartz and held in position for example by a screw 24 which accommodates a rubber ring (not shown in fig.2) and which clamps the holder 22 in a vacuum tight condition. The duct 21 is clamped tight in the holder 22 by a screw 25.

The voltage across the arc preferably is between 20 and 200 volts, particularly in the range 50 to 150 volts. The initiation of plasma generation in the central channel 19 is realised by reducing the arc pressure to a voltage to be applied of approximately 1000 volts, until ignition takes place and a large current starts flowing. (> 10 A for example). Hereafter the pressure is increased rapidly (within 5 seconds for example) until the desired value is reached and the arc is formed after all intermediate-discharge phases have occurred. The cascade-plates 26, for example made of copper, are of simple design. Due to high temperatures (approx. 10.000 Kelvin) and energy-densities in the plasma, the plates must be cooled (by water for example). Channels for carrying the cooling liquid (not shown in fig.2) are situated in the plates close to the central channel 19, thus ensuring good heat-dissipation. The cascade-plates are separated from one another and electrically insulated by means of a sealing system of 'O'-rings 27, spacers 28 (of PVC for example) and central rings made of boron-nitride. The seals ensure that the arc can be maintained at pressures of between 0.05 and 5 bar. The central rings are white in colour and reflect the light radiating from the plasma. The object of the central rings is to act as protection against melting of the 'O'-rings under the influence of plasma light absorption.

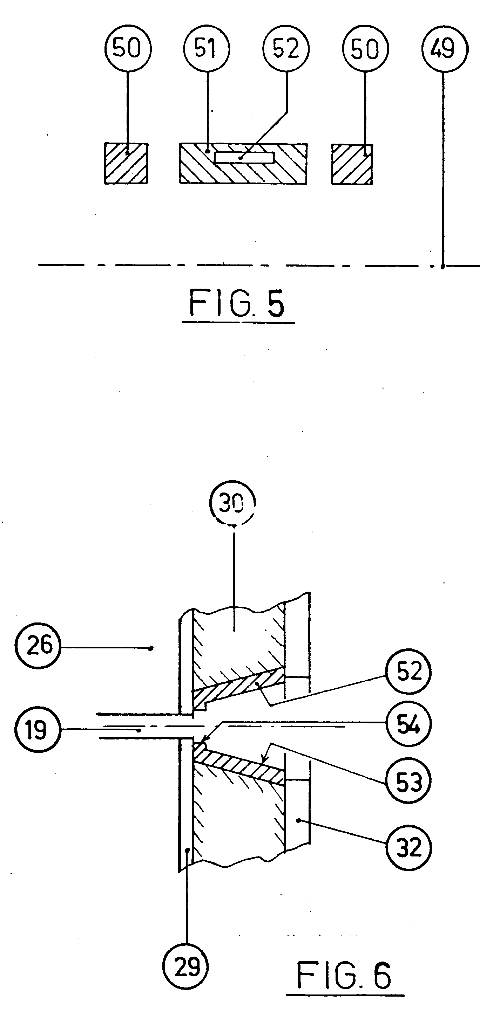

An anode 5 is located at the end of the channel 19 opposite the three cathodes 20. These comprise easily-removable conical inserts each of which is slightly pushed into a conical hole by a clamp ring in a water-cooled plate (made of copper for example). Cooling-water is fed to this cooling-plate via the inlet 31 through the cooling-channel to the outlet 32. The quoted inserts are made of oxygen-free copper for example and are described in more detail with reference to fig.6. The plate 30 is electrically insulated from the housing 1 by an insulating sleeve 33.

A stack of for example 10 cascade-plates is affixed to the anode-plate 30 by a bolt 34 and a nut 35. The bolt 34 is electrically insulated from the housing 1 by means of a sleeve 37, cap 39 and rings 38 and 40. The plasma in the central channel 13 can be observed through the window 41 of window-cap 42 on the window-holder 43. The latter also incorporates the (inlet) passage 12 through which the flushing-gas is fed.

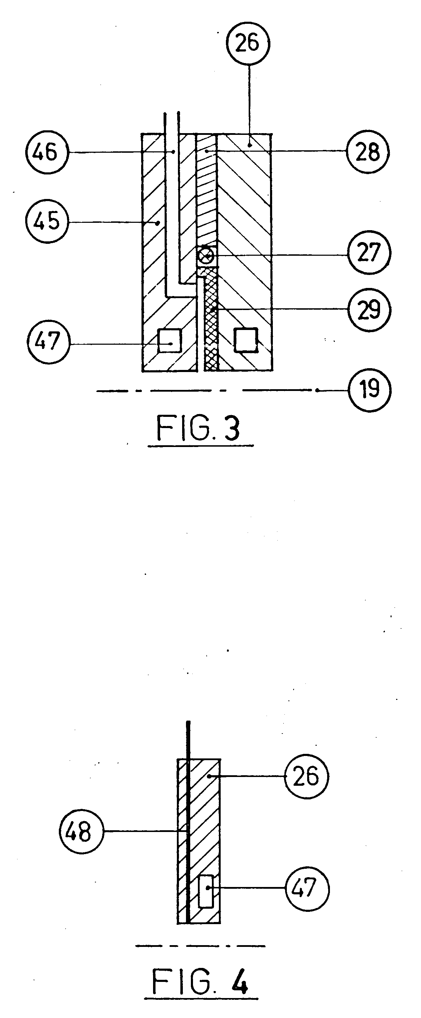

The (inlet) passage for gas-like reactants shown in fig.3 has already been described for the greater part since it comprises two oppositely arranged surfaces of two adjoining cascade-plates 26 and 45 of which at least one plate - 45 - is provided with a channel 46 through which the gas-like reactant can be injected into the central channel 19 via a recess measuring for example 0.1 mm, in the central boron-nitride ring 29. Channel 29 is arranged such that it makes no contact with the cooling-channel 47.

The passage shown in fig.4 for the injection of the liquid reactants into the channel 19 comprises at least one capillary vessel 48, fitted in the cascade-plate 26 such that the cooling-channel 47 is not touched. The diameter of capillary vessel 48 must be chosen such that liquid fed at a higher pressure than that prevailing in the plasma-channel 19 is only vaporised at the end of the capillary vessel where it emerges into the central channel 19.

The possibly used auxiliary discharge device as shown in fig.5 comprises a cathode 51 (provided with a cooling channel 52) which may contain a solid reactant, and an anode 50. Both the cathode and the anode are electrically insulated from the housing shown in fig.1 and are located at a certain distance (10 cm for example) from the symmetry-axis of the plasma stream 8 shown in fig.1.

If this discharge is energised at a voltage of for example between 200 and 1000 volts and with a current density of for example between 50 and 1000 mA/cm$^2$, the reactant material is made gas-like (by sputtering for example) and mixes in the plasma-stream.

Figure 6 shows an example of the construction of a supersonic nozzle which can be used to prevent the deposition of material on undesirable places in the plasma generator. The insert 52 is pressed into the anode-plate 30 by the clamp ring 32 in connective engagement. Initially, the hole in the insert 52 has a diameter which is greater than the diameter of the central channel 15 and thereafter it increases so that the channel emerges at an angle of for example more than 10 degrees with respect to the symmetry-axis of the central channel 19. The inner wall 53 of the insert 52 needs to be finished-off smooth for example with a surface-roughness of less than 0.1 $\mu$m (microns).

Preferably the complete cascade-arc plasma generator is connected to a relatively large vacuum system, so that the plasma can be extracted through the anode-nozzle 5. The pump speed needs to be chosen such that the expansion in the sub-atmospheric plasma treatment-chamber 3 assumes a supersonic character. In that case the equilibrium of the arc-plasma is 'frozen-in'. Three-particles and radiation-recombination processes take too long a time to allow a substantial reduction of the number of reactive plasma particles to occur before reaching the substrate to be treated. Because both the gas- and electron temperature in the arc-plasma have a value of approximately 10.000 Kelvin, the sound-speed is 1750 meters/per second. This fact limits the mass-flow, as the sound-speed is reached there, where the diameter is smallest (in the majority of cases this is at the nozzle or at the end of the arc-channel).

Alongside supersonic expansion, another effect arises, strengthening considerably the efficiency of the process. Since the electrons have a greater degree of mobility than the ions, they will easily migrate to the outermost regions of expansion. Thus, such a spatial-discharge distribution is created in a situation, of equilibrium, that the resulting electric-field strength retards the electron flow to such an extent that they will diffuse at the same rate as the ions (ambipolar-diffusion concept). In combination with the high systematic gas speed in the supersonic expansion, the electrons in the plasma are held together, so that an intense plasma-stream exists. The ionisation-equilibrium in the arc-plasma will now be transported in an efficient manner to the substrate to be treated. The neutral particles can now easily expand and a number of them will never reach the substrate 9.

Because the time needed by the reactive particles after extraction from the plasma generator to cross over to the substrate is only 1 millisecond approximately, it is unlikely that the relative composition of the plasma-stream changed by recombination or by other associated processes.

## Claims

1. A method of plasma treatment of substrate surfaces, in which the plasma is generated in at least one plasma arc generator (13) of the type including a plurality of cascade plates (26, 45) wherein the generator (13) is flushed with flushing gas, wherein the plasma gets from the generator (13) through a passage (4, 32) into the plasma-treatment-chamber (3), where the pressure is substantially lower than that in the generator (13),
characterised in that a fluid reactant is introduced into the generator (13) through at least one channel (46, 48), located in one or between two plates (26, 45), it being fed downstream with respect to the cathode(s) and only after the flushing gas has passed said cathode-(s).

2. A method as claimed in claim 1,
characterised in that the molecules from which the flushing gas is built up, do not contain fragments which would react with the cathode material.

3. A method as claimed in any of the preceding claims,
characterised in that back diffusion of (parts of) the reactant to the cathode(s) is strongly retarded or prevented by the flushing gas flowing at a rate of at least 1 meter/per second, preferably at at least 10 meters/per second.

4. A method as claimed in any of the preceding claims,
characterised in that during operation the temperature of the cathode(s) is maintained beneath the melting temperature of the cathode-(s).

5. A method as claimed in any of the preceding claims,
characterised in that the liquid reactant is injected into the generator through at least one aperture with a diameter of between 0.0001 to 0.5 mm and preferably of between 0.005 to 0.1 mm in the wall of the said generator.

6. A method as claimed in claim 5,
characterised in that the liquid pressure just prior to the aperture is greater than the pressure in the generator.

7. A method as claimed in any of the preceding claims,
characterised in that at least one extra discharge takes place in the plasma treatment-chamber, freeing particles of a solid matter into the gas-phase.

8. A method as claimed in any of the preceding claims,
characterised in that the rate at which the plasma treatment-chamber is pumped out, is adjustable between 0 to 100.000 liters/second, preferably however from 50 to 1000 liters/second.

9. A method as claimed in any of the preceding claims,
characterised in that the diameter of the plasma-stream generated by generator is controlled.

10. A method as claimed in claim 9,
characterised in that the said controlling action is performed by passing the plasma-stream through a skimmer.

11. A method as claimed in claim 9 or claim 10,
characterised in that the said controlling action is performed by subjecting it to a magnetic field.

12. A method as claimed in any of the preceding claims,
characterised in that the supplementation of the reactant to the generator first takes place at the extreme end of the said generator, in this case the plasma-passage.

13. A method as claimed in any of the preceding claims,
characterised in that the temperature of the substrate to be treated is set between 70 and 1500 Kelvin and preferably between 273 and 1000 Kelvin.

14. A reactor for carrying out the method as claimed in any of the preceding claims, comprising a plasma arc generator (13), of the type, having a plurality of cascade plates (26), having an inlet for flushing gas and having at least one plasma passage (4, 32) into a plasma treatment-chamber (3),
characterised in that the generator (13) has at least one channel (46, 48) located in one or between two plates (26, 45), through which channel (5) a fluid reactant can be introduced, said channel (46, 48) being located after (downstream with respect to) the cathode(s).

15. A reactor as claimed in claim 14 for carrying out the method as claimed in claim 4,
characterised in that the cathode(s) is (are) made of a material having a high electron-emission characteristic and preferably of an alloy of between 0.1 to 10% thorium in wolfram.

16. A reactor as claimed in claims 14 and 15, wherein said fluid reactant is a liquid reactant and wherein the corresponding channel (48) has an opening towards the main channel (19) where the opening has a diameter of between 0.001 and 0.5 mm, preferably between 0.005 and 0.1 mm.

17. A reactor as claimed in any of the claims 14 to 16,
characterised in that the plasma generator(s) and the plasma-inlet (outlets) is (are) so geometrically arranged that when viewed along the direction of flow, no sudden restrictions can arise in the formed channel(s).

18. A reactor as claimed in claim 17,
characterised in that the diameter of the channel formed by the plasma generator(s) and the plasma-passage gradually changes diameter when viewed in the flow-direction with respect to the cathode(s).

19. A reactor as claimed in any of claims 14 to 18 for carrying out the method as claimed in claim 8,
characterised in that the plasma treatment-chamber vacuum system is provided with means for setting the rate at which the said plasma treatment-chamber can be pumped out between a value of 0 to 100.000 liters/per second and preferably between 50 and 1000 liters/per second.

20. A reactor as claimed in any of claims 14 to 17 for carrying out the method as claimed in claim 10,
characterised in that the plasma treatment-chamber is provided with a skimmer.

21. A reactor as claimed in any of claims 14 to 20 for carrying out the method as claimed in claim 11,
characterised in that the plasma treatment-chamber is provided with means for generating a magnetic field.

22. A reactor as claimed in any of claims 14 to 20 for carrying out the method claimed in claim 11,
characterised in that the generator (2) and the plasma treatment-chamber incorporate means for setting the temperature of the substrate between 70 and 1500 Kelvin and preferably between 273 to 1000 Kelvin.

**Patentansprüche**

1. Ein Verfahren zur Plasmabehandlung von Substratoberflächen, bei dem das Plasma in zumindest einem Plasma-Lichtbogengenerator (13) des Typs erzeugt wird, der eine Vielzahl Kaskadenplatten (26, 45) einschließt, worin der Generator (13) mit Spülgas gespült wird, worin das Plasma vom Generator (13) durch eine Passage (4, 32) in die Plasma-Behandlungskammer (3) gelangt, wo der Druck wesentlich niedriger als im Generator (13) ist, dadurch gekennzeichnet, daß ein flüssiges Reaktionsmittel in den Generator (13) über zumindest einen Kanal (46, 48), der sich in einer oder zwischen zwei Platten (26, 45) befindet, eingeleitet wird, und erst nachdem das Spülgas besagte Kathode(n) passiert hat, es bezogen auf die Kathode(n) abwärts geleitet wird,

2.   Ein Verfahren wie in Anspruch 1 geltend gemacht, dadurch gekennzeichnet, daß die Moleküle, aus denen das Spülgas aufgebaut ist, keine Bruchstücke enthalten, die mit dem Kathodenwerkstoff reagieren würden.

3.   Ein Verfahren wie in irgendeinem der vorher genannten Ansprüche geltend gemacht, dadurch gekennzeichnet, daß ein rückwärtiges Ausbreiten von (Teilen des) Reaktionsmittel(s) zu der oder den Kathode(n) stark verzögert oder verhindert wird, dadurch daß das Spülgas mit einer Geschwindigkeit von zumindest 1 Meter pro Sekunde, vorzugsweise zumindest 10 Meter pro Sekunde strömt.

4.   Ein Verfahren wie in irgendeinem der vorher genannten Ansprüche geltend gemacht, dadurch gekennzeichnet, daß die Temperatur der Kathode(n) während des Betriebs unterhalb der Schmelztemperatur der Kathode(n) gehalten wird.

5.   Ein Verfahren wie in irgendeinem der vorher genannten Ansprüche geltend gemacht, dadurch gekennzeichnet, daß das flüssige Reaktionsmittel in den Generator durch zumindest eine Öffnung in der Wand von besagtem Generator mit einem Durchmesser von zwischen 0,0001 und 0,5 mm und vorzugsweise von zwischen 0,005 und 0,1 mm injiziert wird.

6.   Ein Verfahren wie in Anspruch 5 geltend gemacht, dadurch gekennzeichnet, daß der Druck der Flüssigkeit unmittelbar vor der Öffnung größer als der Druck im Generator ist.

7.   Ein Verfahren wie in irgendeinem der vorher genannten Ansprüche geltend gemacht, dadurch gekennzeichnet, daß zumindest eine zusätzliche Entladung in der Plasma-Behandlungskammer stattfindet, um Feststoff-Teilchen in die Gasphase zu überführen.

8.   Ein Verfahren wie in irgendeinem der vorher genannten Ansprüche geltend gemacht, dadurch gekennzeichnet, daß die Geschwindigkeit, mit der die Plasma-Behandlungskammer leergepumpt wird, auf Werte zwischen 0 und 100.000 Liter pro Sekunde, vorzugsweise aber auf Werte zwischen 50 und 1000 Liter pro Sekunde eingestellt werden kann.

9.   Ein Verfahren wie in irgendeinem der vorher genannten Ansprüche geltend gemacht, dadurch gekennzeichnet, daß der Durchmesser des Plasmastroms, der im Generator erzeugt wird, kontrolliert werden kann.

10.   Ein Verfahren wie in Anspruch 9 geltend gemacht, dadurch gekennzeichnet, daß besagte Kontrolle dadurch ausgeführt wird, daß der Plasmastrom durch einen Skimmer ('Schaumlöffel') geleitet wird.

11.   Ein Verfahren wie in Anspruch 9 oder 10 geltend gemacht, dadurch gekennzeichnet, daß besagte Kontrolle dadurch ausgeführt wird, daß ein magnetisches Feld angewandt wird.

12.   Ein Verfahren wie in irgendeinem der vorher genannten Ansprüche geltend gemacht, dadurch gekennzeichnet, daß die Auffüllung des Reaktionsmittels im Generator erst am äußersten Ende des besagten Generators stattfindet, in diesem Fall in der Passage für das Plasma.

13.   Ein Verfahren wie in irgendeinem der vorher genannten Ansprüche geltend gemacht, dadurch gekennzeichnet, daß die Temperatur des zu behandelnden Substrats zwischen 70 und 1500 Kelvin beträgt und vorzugsweise zwischen 273 und 1000 Kelvin.

14.   Ein Reaktor zur Durchführung des Verfahrens wie in irgendeinem der vorher genannten Ansprüche geltend gemacht, bestehend aus einem Plasma-Lichtbogengenerator (13) des Typs, der eine Vielzahl Kaskadenplatten (26) besitzt, einen Einlaß für Spülgas hat und zumindest eine Plasmapassage (4, 32), die in eine Plasma-Behandlungskammer (3) führt, dadurch gekennzeichnet, daß der Generator (13) zumindest einen Kanal (46, 48) hat, der sich in einer oder zwischen zwei Platten (26, 45) befindet, durch welchen Kanal (5) ein flüssiges Reaktionsmittel eingebracht werden kann, besagter Kanal (46, 48) hinter (d.h. bezogen auf die Kathode(n) stromabwärts) der oder den Kathode(n) angeordnet ist.

15. Ein Reaktor wie in Anspruch 14 geltend gemacht zur Durchführung des Verfahrens wie in Anspruch 4 beansprucht,
dadurch gekennzeichnet, daß die Kathode(n) aus einem Werkstoff mit einer hohen Elektronen-Emissions-Charakteristik gefertigt ist (sind) und vorzugsweise aus einer Legierung aus 0,1 bis 10% Thorium in Wolfram besteht.

16. Ein Reaktor wie in den Ansprüchen 14 und 15 geltend gemacht, worin besagtes fließendes Reaktionsmittel ein flüssiges Reaktionsmittel ist und worin der entsprechende Kanal (48) eine Öffnung zum Hauptkanal (19) hat, wobei die Öffnung einen Durchmesser von zwischen 0,001 und 0,5 mm, vorzugsweise zwischen 0,005 und 0,1 mm hat.

17. Ein Reaktor wie in irgendeinem der Ansprüche 14 bis 16 geltend gemacht,
dadurch gekennzeichnet, daß der (die) Plasmagenerator(en) und der Einlaß (Auslaß) für das Plasma räumlich so angeordnet ist (sind), daß, in Strömungsrichtung gesehen, keine plötzlichen Verengungen in dem (den) gebildeten Kanal (Kanälen) entstehen können.

18. Ein Reaktor wie in Anspruch 17 geltend gemacht,
dadurch gekennzeichnet, daß der Durchmesser des Kanals, der von dem (den) Plasma-Generator(en) und der Plasmapassage gebildet wird, sich allmählich ändert, gesehen in Strömungsrichtung und unter Bezugnahme auf die Kathode(n).

19. Ein Reaktor wie in irgendeinem der Ansprüche 14 bis 18 geltend gemacht zur Durchführung des Verfahrens wie in Anspruch 8 beansprucht,
dadurch gekennzeichnet, daß das Vakuumsystem der Plasma-Behandlungskammer mit Vorrichtungen versehen ist, die es ermöglichen die Geschwindigkeit, mit der die besagte Plasma-Behandlungskammer leergepumpt werden kann, auf einen Wert zwischen 0 und 100.000 Liter pro Sekunde und vorzugsweise zwischen 50 und 1000 Liter pro Sekunde einzustellen.

20. Ein Reaktor wie in irgendeinem der Ansprüche 14 bis 17 geltend gemacht zur Durchführung des Verfahrens wie in Anspruch 10 beansprucht,

dadurch gekennzeichnet, daß die Plasma-Behandlungskammer mit einem Skimmer versehen ist.

21. Ein Reaktor wie in irgendeinem der Ansprüche 14 bis 20 geltend gemacht zur Durchführung des Verfahrens wie in Anspruch 11 beansprucht,
dadurch gekennzeichnet, daß die Plasma-Behandlungskammer mit Vorrichtungen zur Erzeugung eines magnetischen Feldes versehen ist.

22. Ein Reaktor wie in irgendeinem der Ansprüche 14 bis 20 geltend gemacht zur Durchführung des Verfahrens wie in Anspruch 11 beansprucht,
dadurch gekennzeichnet, daß der Generator und die Plasma-Behandlungskammer über Möglichkeiten verfügen, um die Temperatur des Substrats auf Werte zwischen 70 und 1500 Kelvin und vorzugsweise zwischen 273 und 1000 Kelvin einzustellen.

**Revendications**

1. Une méthode de traitement par plasma de surfaces de substrats, dans laquelle le plasma est généré dans au moins un générateur de plasma à arc (13), du type comprenant une pluralité de plaques en cascade (26,45), le générateur (13) étant baigné par un gaz s écoulant, le plasma passant du générateur (13) par un passage (4,32) vers la chambre de traitement du plasma (3), où la pression est bien inférieure à celle dans le générateur (13), caractérisée en ce que un réactif fluide est introduit dans le générateur (13) par au moins un canal (46,48) situé dans une plaque ou entre deux plaques (26,45), le réactif étant introduit en aval de la ou des cathodes, et seulement après que le gaz s'écoulant ait passé cette ou ces cathodes.

2. Une méthode comme revendiquée dans la revendication 1,
caractérisée en ce que les molécules qui constituent le gaz s'écoulant ne contiennent pas de fragments qui pourraient réagir avec le matériau de la cathode.

3. Une méthode comme revendiquée dans une des revendications précédentes,
caractérisée en ce que la diffusion vers l'arrière de (parties de) réactif vers la ou les cathodes est fortement retardée ou empêchée par le gaz s'écoulant à une vitesse d'au moins 1 mètre par seconde, et de préférence d'au moins 10 mètres par seconde.

**4.** Une méthode comme revendiquée dans une des revendications précédentes, caractérisée en ce que pendant l'opération, la température de la ou des cathodes est maintenue en-dessous de la température de fusion de la ou des cathodes.

**5.** Une méthode comme revendiquée dans une des revendications précédentes, caractérisée en ce que le réactif liquide est injecté dans le générateur par au moins une ouverture dans la paroi du générateur, d'un diamètre compris entre 0,0001 et 0,5 mm, et de préférence entre 0,005 et 0,1 mm.

**6.** Une méthode comme revendiquée dans la revendication 5. caractérisée en ce que la pression du liquide juste avant l'ouverture est supérieure à la pression dans le générateur.

**7.** Une méthode comme revendiquée dans une des revendications précédentes, caractérisée en ce que au moins une décharge supplémentaire a lieu dans la chambre de traitement du plasma, libérant des particules d'une matière solide dans la phase gazeuse.

**8.** Une méthode comme revendiquée dans une des revendications précédentes, caractérisée en ce que la vitesse à laquelle la chambre de traitement du plasma est pompée est ajustable entre 0 et 100 000 litres par seconde, et de préférence cependant entre 50 et 1 000 litres par seconde.

**9.** Une méthode comme revendiquée dans une des revendications précédentes, caractérisée en ce que le diamètre du flux de plasma généré par le générateur est contrôlé.

**10.** Une méthode comme revendiquée dans la revendication 9, caractérisée en ce que ce contrôle est effectué en faisant passer le flux de plasma par une écumoire.

**11.** Une méthode comme revendiquée dans la revendication 9 ou la revendication 10, caractérisée en ce que ce contrôle est effectué en étant soumis à un champ magnétique.

**12.** Une méthode comme revendiquée dans une des revendications précédentes, caractérisée en ce que l'ajout du réactif dans le générateur a d'abord lieu à l'extrémité de ce générateur, c'est-à-dire dans ce cas le passage pour le plasma.

**13.** Une méthode comme revendiquée dans une des revendications précédentes, caractérisée en ce que la température du substrat à traiter est fixée entre 70 et 1 500 Kelvin, et de préférence entre 273 et 1 000 Kelvin.

**14.** Un réacteur pour réaliser la méthode comme revendiquée dans une des revendications précédentes, comprenant un générateur de plasma à arc (13), du type comportant une pluralité de plaques en cascade (26), comprenant une arrivée pour un gaz s'écoulant et au moins un passage pour le plasma (4,32) vers une chambre de traitement du plasma (3), caractérisé en ce que le générateur (13) comprend au moins un canal (46,48) situé dans une plaque ou entre deux plaques (26,45), un réactif fluide pouvant être introduit par ce canal (5), ce canal (46,48) étant situé après (en aval par rapport à) la ou les cathodes.

**15.** Un réacteur comme revendiqué dans la revendication 14 pour réaliser la méthode comme revendiquée dans la revendication 4, caractérisé en ce que la ou les cathodes sont faîtes d'un matériau caractérisé par une forte émission d'électrons, et de préférence d'un alliage de 0,1 à 10 % de thorium dans du tungstène.

**16.** Un réacteur comme revendiqué dans les revendications 14 et 15, dans lequel le réactif fluide est un réactif liquide et dans lequel le canal correspondant (48) comporte une ouverture vers le canal principal (19), l'ouverture ayant un diamètre compris entre 0,001 et 0,5 mm, et de préférence entre 0,005 et 0,1 mm.

**17.** Un réacteur comme revendiqué dans une des revendications 14 à 16, caractérisé en ce que le ou les générateurs de plasma ainsi que l'arrivée (et les sorties) de plasma sont disposés géométriquement de façon à ce que, vu dans la direction du flux, aucune restriction soudaine ne puisse survenir dans le ou les canaux formés.

**18.** Un réacteur comme revendiqué dans la revendication 17, caractérisé en ce que le diamètre du canal formé par le ou les générateurs de plasma et le passage pour le plasma change graduellement, vu dans la direction du flux par rapport à la ou aux cathodes.

**19.** Un réacteur comme revendiqué dans l'une des revendications 14 à 18 pour réaliser la méthode comme revendiquée dans la revendication 8,

caractérisé en ce que le système sous vide de la chambre de traitement du plasma comporte un dispositif pour fixer la vitesse à laquelle cette chambre de traitement du plasma peut être pompée, à une valeur comprise entre 0 et 100 000 litres par seconde, et de préférence entre 50 et 1 000 litres par seconde.

**20.** Un réacteur comme revendiqué dans l'une des revendications 14 à 17 pour réaliser la méthode comme revendiquée dans la revendication 10,

caractérisé en ce que la chambre de traitement du plasma comporte une écumoire.

**21.** Un réacteur comme revendiqué dans l'une des revendications 14 à 20 pour réaliser la méthode comme revendiquée dans la revendication 11,

caractérisé en ce que la chambre de traitement du plasma comporte un dispositif pour générer un champ magnétique.

**22.** Un réacteur comme revendiqué dans l'une des revendications 14 à 20 pour réaliser la méthode comme revendiquée dans la revendication 11,

caractérisé en ce que le générateur (2) et la chambre de traitement du plasma comprennent un dispositif pour fixer la température du substrat entre 70 et 1 500 Kelvin, et de préférence entre 273 et 1 000 Kelvin.

FIG. 1

FIG 2

FIG. 3

FIG. 4

14

FIG. 5

FIG. 6